# EUROPEAN PATENT APPLICATION

(11) **EP 4 528 912 A1**
(43) Date of publication of application: **26.03.2025**
(21) Application number: 24170008.7
(22) Date of filing: 12.04.2024
(51) Int. Cl.: H01M 50/569, H01M 10/42, G01K 7/02, G01R 31/36, G01R 31/382, G01R 31/385, H01M 10/48, H01M 50/284, H01M 50/298, H01M 50/287

(54) **APPARATUS FOR MEASURING BATTERY TEMPERATURE**

(30) Priority: 20.09.2023 KR 20230125851
(71) Applicant: Samsung SDI Co., Ltd., Yongin-si, Gyeonggi-do 17084 (KR)
(72) Inventor: YOO, Junho, 17084 Yongin-si (KR); KIM, Jaeseung, 17084 Yongin-si (KR); KWAG, Nohyun, 17084 Yongin-si (KR); JEONG, Hyeoncheol, 17084 Yongin-si (KR)
(74) Representative: Marks & Clerk LLP

(57) **Abstract**

A temperature measurement apparatus for measuring a temperature of a battery cell includes a temperature measurement board including at least one temperature sensor, the temperature measurement board being on an integrated circuit board, a plating layer on a first surface of the temperature measurement board and electrically connected to the battery cell to allow a charging/discharging current of the battery cell to flow therethrough, the plating layer being a metal layer, and at least one temperature measurement pattern on a second surface of the temperature measurement board and electrically connected to the at least one temperature sensor, the second surface being opposite the first surface, and the at least one temperature measurement pattern being a conductive pattern.

## Description

### BACKGROUND

### 1. Field

One or more embodiments relate to an apparatus for measuring a battery temperature.

### 2. Description of the Related Art

Recently, as the demand for portable electronic products, e.g., laptops, video cameras, portable phones, etc., has increased, and also as the development of electric vehicles, energy storage batteries, robots, satellites, etc., has advanced, research directed to high-performance secondary batteries that may be repeatedly charged and discharged has been actively pursued. Current commercial secondary batteries include nickel cadmium batteries, nickel hydrogen batteries, nickel zinc batteries, lithium secondary batteries, etc. Among these secondary batteries, lithium secondary batteries have been highlighted because they can be charged and discharged freely with little memory effect (e.g., compared to nickel-based secondary batteries) and also they have very low self-discharge rate and high energy density.

Secondary batteries are used in various fields, e.g., electric vehicles or smart grid systems, and often require large capacities. To increase the capacities of battery packs, a capacity of a single secondary battery, i.e., a battery cell, may be increased. In this case, since a capacity increase of a single secondary battery may not be significant, a size expansion of the single secondary battery may be physically limited, and management of the single second battery may be difficult, a battery pack, in which a plurality of battery cells are connected in series and in parallel, may be used.

The battery pack may often include a battery management system (BMS) that manages a battery module that includes a plurality of battery cells. Moreover, the BMS may monitor the temperature, voltage, current, etc., of the battery module, and may control a balancing operation, a cooling operation, a charging operation, a discharging operation, etc., of the battery pack based on the monitored state of the battery module.

A temperature of the battery module, i.e. a temperature of the secondary battery, may be a factor highly influencing the performance of the battery pack. Generally, the battery pack may operate efficiently if the temperature of the secondary battery has a proper temperature distribution. For example, if the temperature of the secondary battery is excessively high, the performance of the battery pack may be degraded due to reduction of safety of a cathode crystal lattice of the secondary battery, etc. If the temperature of the secondary battery is excessively low, the performance of the battery pack may be degraded due to charging/discharging capacity reduction, etc., caused by an increased internal resistance and polarization voltage of the secondary battery.

### SUMMARY

One or more embodiments of the present disclosure include an apparatus for measuring a battery temperature. Additional aspects will be set forth in part in the description which follows and, in part, will be apparent from the description, or may be learned by practice of the presented embodiments of the present disclosure.

According to one or more embodiments, a temperature measurement apparatus for measuring a temperature of a battery cell includes or comprises a temperature measurement board including a temperature sensor and mounted on an integrated circuit board, a plating layer formed as a metal material on a surface of the temperature measurement board and electrically connected to the battery cell to allow a charging/discharging current of the battery cell to flow therethrough, and a temperature measurement pattern formed as a conductive pattern on another surface of the temperature measurement board and electrically connected to the temperature sensor provided on the temperature measurement board.

According to another aspect of the present invention there is provided a temperature measurement apparatus for measuring a temperature of a battery cell, the temperature measurement apparatus comprising: a temperature measurement board including at least one temperature sensor, the temperature measurement board being on an integrated circuit board; a plating layer on a first surface of the temperature measurement board and electrically connected to the battery cell to allow a charging/discharging current of the battery cell to flow therethrough, the plating layer being a metal layer; and at least one temperature measurement pattern on a second surface of the temperature measurement board and electrically connected to the at least one temperature sensor, the second surface being opposite the first surface, and the at least one temperature measurement pattern being a conductive pattern.

In some embodiments, the plating layer may comprise a copper foil plating layer.

In some embodiments, the plating layer may further comprise a nickel and gold plating layer.

In some embodiments, the plating layer may be formed or configured to allow the charging/discharging current for measuring a voltage and a current of the battery cell to flow therethrough.

In some embodiments, an end of the (at least one) temperature measurement pattern may be electrically connected to the (at least one) temperature sensor to allow a temperature sensing current for measuring the temperature of the battery cell to flow therethrough.

In some embodiments, a plurality of temperature measurement patterns may be provided and respectively electrically connected to a plurality of temperature sensors.

In some embodiments, the at least one temperature measurement pattern includes a plurality of temperature measurement patterns on the second surface of the temperature measurement board, and the at least one temperature sensor includes a plurality of temperature sensors, the plurality of temperature measurement patterns being electrically connected to corresponding ones of the plurality of temperature sensors.

In some embodiments, the plating layer may be electrically connected to the battery cell by a wire or by wire bonding.

In some embodiments, the temperature measurement apparatus may further include a fixing rib. It may be provided at a side of the temperature measurement board and may comprise at least one groove fixed to a protrusion (a protrusive fixing portion) of the integrated circuit board.

According to one or more embodiments, a battery management system (BMS) comprises or includes the temperature measurement apparatus described above.

According to one or more embodiments, a battery pack comprises or includes the BMS with the temperature measurement apparatus described above.

At least some of the above and other features of the invention are set out in the claims.

### BRIEF DESCRIPTION OF THE DRAWINGS

The above and other aspects, features and advantages of certain embodiments will become apparent to those of skill in the art from the following description, as made, purely by way of example, with reference to the attached drawings, in which:
FIG. 1 schematically shows a structure of a temperature measurement apparatus mounted on a battery module according to an embodiment of the present disclosure;
FIG. 2 schematically shows a temperature measurement apparatus according to an embodiment of the present disclosure;
FIG. 3 schematically shows a fixing rib of a temperature measurement apparatus according to an embodiment of the present disclosure; and
FIG. 4 schematically shows an enlarged view of the fixing rib of the temperature measurement apparatus on an integrated circuit board of a battery management system (BMS) according to an embodiment of the present disclosure.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey example implementations to those skilled in the art.

In the drawings, the dimensions of layers and regions may be exaggerated for clarity of illustration. It will also be understood that when a layer or element is referred to as being "on" another layer or substrate, it can be directly on the other layer or substrate, or intervening layers may also be present. In addition, it will also be understood that when a layer is referred to as being "between" two layers, it can be the only layer between the two layers, or one or more intervening layers may also be present.

Like reference numerals refer to like elements throughout.

Expressions such as "at least one of," if preceding a list of components, modify the entire list of components and do not modify the individual components of the list.

The terms and words used in the present specification and claims should not be construed as being limited to ordinary or dictionary meanings, and should be interpreted as meanings and concepts consistent with the technical idea of the present disclosure based on the principle that the present inventors may appropriately define the concept of the terms to describe their invention in the best way.

Therefore, it should be understood that the configurations shown in the drawings and embodiments described in this specification are merely the most preferred embodiments of the present disclosure, and do not represent all of the technical ideas of the present disclosure, such that there may be various equivalents and variations that replace them at the time of filing the present application.

In describing the present disclosure in detail, if it is determined that a detailed description of a related known function or configuration may unnecessarily obscure the subject matter of the present disclosure, the detailed description will be omitted.

Throughout the entirety of the specification of the present disclosure, if it is assumed that a certain part includes a certain component, the term "including" means that a corresponding component may further include other components unless specially described to the contrary. Further, throughout the specification, if any portion is "connected" to another portion, it may include not only a case where they are "directly connected", but also a case where they are "indirectly connected" with another element therebetween.

Herein, a single secondary battery may refer to one independent cell that includes a cathode terminal and an anode terminal and is physically separable.

An apparatus for measuring a battery temperature according to the present disclosure may measure a temperature of a battery. Herein, the battery may include one or more secondary batteries. The apparatus for measuring a battery temperature according to the present disclosure may measure a temperature of at least one secondary battery among secondary batteries provided in a battery pack. The apparatus for measuring a battery temperature according to the present disclosure may be applied to a battery including one or more lithium secondary batteries. Herein, the battery may be a concept including a battery module or a battery pack.

The apparatus for measuring a battery temperature according to embodiments of the present disclosure may measure a temperature of a secondary battery by using a temperature sensor mounted on an integrated circuit board. Herein, the integrated circuit board may be configured to contact an electrode lead of the secondary battery. For example, the integrated circuit board may directly contact the electrode lead of the secondary battery. In this case, the integrated circuit board may include a connector configured to directly contact the electrode lead of the secondary battery, and may contact the electrode lead of the secondary battery through the connector.

For example, the integrated circuit board may indirectly contact the electrode lead of the secondary battery. In this case, the integrated circuit board may include a connector configured to directly contact a sensing bus bar connecting the electrode lead of the secondary battery to the integrated circuit board, thus contacting the electrode lead of the secondary battery through the sensing bus bar.

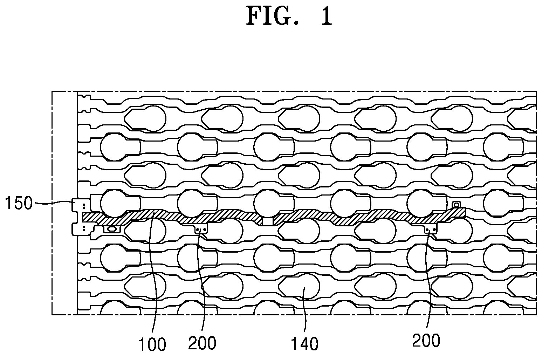

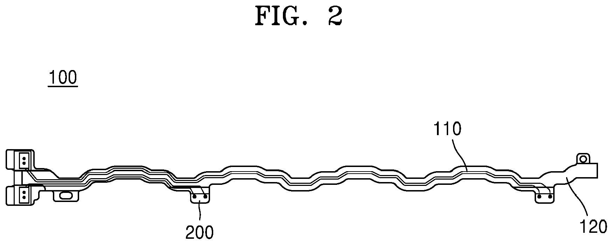

FIG. 1 schematically shows a structure where a temperature measurement apparatus according to embodiments of the present disclosure is mounted on a battery module. FIG. 2 schematically shows a temperature measurement apparatus according to embodiments of the present disclosure.

The temperature measurement apparatus according to embodiments of the present disclosure may be mounted on a battery module. Herein, the battery module may include a plurality of battery cells. The temperature measurement apparatus according to embodiments of the present disclosure may be included in the BMS. The temperature measurement apparatus according to embodiments of the present disclosure may be included in the battery pack. The temperature measurement apparatus according to embodiments of the present disclosure may measure a temperature of a battery cell.

In the battery module including the temperature measurement apparatus according to embodiments of the present disclosure, unlike in the conventional battery module, a voltage and a temperature of a battery cell may be measured at a time (i.e. the same time (e.g., simultaneously)) by using the temperature measurement apparatus, instead of separately measuring each of the voltage and the temperature of the battery cell.

Referring to FIGS. 1 and 2 together, the temperature measurement apparatus (hatched shape in FIG. 1) according to embodiments of the present disclosure may include a temperature measurement board 100, a plating layer 120, and a temperature measurement pattern 110. Further, the temperature measurement apparatus may include a temperature sensor 200, e.g., a thermistor.

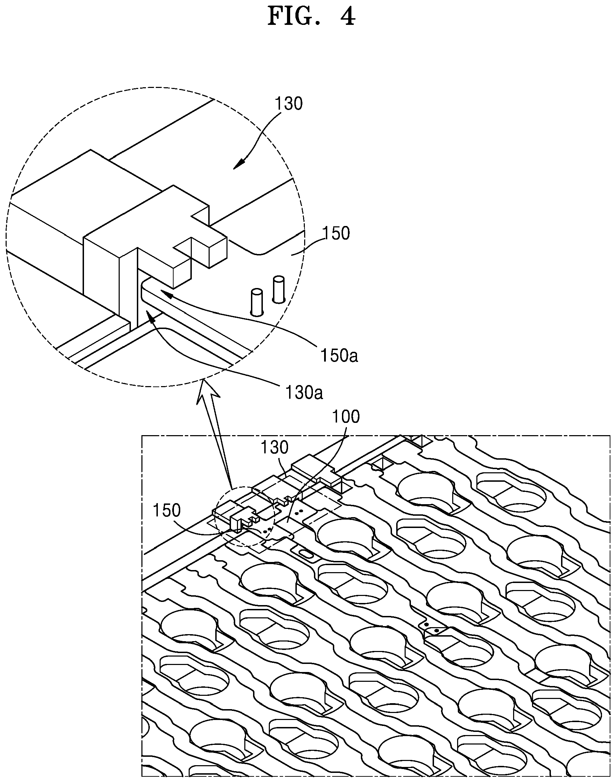

For example, the temperature measurement board 100 may be mounted on an integrated circuit board 150, e.g., an edge of the temperature measurement board 100 may be on an integrated circuit board of a battery management system (BMS) (FIGS. 1 and 4). The temperature measurement board 100 may include the temperature sensor 200, e.g., the temperature sensor 200 may be connected to a portion of the temperature measurement board 100. For example, referring to FIGS. 1 and 2, the temperature measurement board 100 may have an elongated shape positioned on the battery module, and may extend, e.g., continuously, between adjacent rows of battery cells 140. For example, referring to FIGS. 1 and 2, the temperature measurement board 100 may be in a space between adjacent rows of battery cells 140, and the temperature sensor 200 may be on a portion of the temperature measurement board 100 extending laterally from a main body of the temperature measurement board 100. For example, referring to FIG. 1, if adjacent rows of the battery cells 140 are offset with respect to each other, the temperature sensor 200 may have sufficient space to extend laterally from the main body of the temperature measurement board 100 between the adjacent rows into a space between two battery cells within a same row

The temperature measurement board 100 may include the plating layer 120 on a (first) surface (e.g., a top surface) thereof. The temperature measurement board 100 may include the temperature measurement pattern 110 on another (a second) surface (e.g., a bottom surface) thereof. For example, the plating layer 120 and the temperature measurement pattern 110 may be on (e.g., directly on) opposite surfaces of the temperature measurement board 100.

For example, referring to FIG. 2, the plating layer 120 may include a metal material (e.g., may be a metal layer) and may be formed on a surface of the temperature measurement board 100. The plating layer 120 may be electrically connected to the battery cell and may be formed to allow the charging/discharging current of the battery cell to flow therethrough. For example, the plating layer 120 may include a gold (Au) plating layer on the top surface of the temperature measurement board 100. For example, the plating layer 120 may be electrically connected to the battery cell by wire bonding.

The plating layer 120 according to embodiments of the present disclosure may be formed to allow charging/discharging current for measuring a voltage and a current of the battery cell to flow therethrough. For example, the charging/discharging current of the battery cell may flow through the plating layer 120, and the BMS may measure the voltage based on the charging/discharging current flowing through the plating layer 120. The BMS may measure a current based on the charging/discharging current flowing through the plating layer 120.

For example, the plating layer 120 according to embodiments of the present disclosure may include a copper foil (Cu) plating layer. In another example, the plating layer 120 according to embodiments of the present disclosure may include a nickel (Ni) and gold (Au) plating layer. In yet another example, the plating layer 120 according to embodiments of the present disclosure may further include a copper foil (Cu), nickel (Ni), and gold (Au) plating layer.

The temperature measurement pattern 110, as a conductive pattern, may be formed on another surface of the temperature measurement board 100. For example, referring to FIG. 2, the temperature measurement pattern 110 may be electrically connected to the temperature sensor 200 included in the temperature measurement board 100.

The temperature measurement pattern 110 according to embodiments of the present disclosure may be electrically connected to the temperature sensor 200 at an end thereof to allow a temperature sensing current for measuring the temperature of the battery cell to flow therethrough. For example, the temperature measurement pattern 110 may be printed on the temperature measurement board 100. In another example, the temperature measurement pattern 110 may be buried in the temperature measurement board 100. For example, as illustrated in FIG. 2, the temperature measurement pattern 110 may extend along the main body of the temperature measurement board 100 only to the position of the temperature sensor 200.

A plurality of temperature measurement patterns 110 according to embodiments of the present disclosure may be provided to electrically connect to a plurality of temperature sensors 200, respectively. For example, referring to FIG. 2, a plurality of temperature measurement patterns 110 may be positioned on a same surface of a single temperature measurement board 100 to be electrically connected to a plurality of temperature sensors 200, respectively, e.g., the number of the plurality of temperature measurement patterns 110 may equal the number of the plurality of temperature sensors 200 to be connected in a one-to-one correspondence. For example, as illustrated in FIG. 2, two temperature measurement patterns 110 according to embodiments of the present disclosure may be provided (for example on a single temperature measurement board 100) to electrically connect to two temperature sensors 200, respectively.

While a single temperature sensor is provided in a conventional battery module due to space limitation, a battery module according to the present disclosure may include a plurality (e.g., two) temperature sensors due to space optimization. Accordingly, accuracy of temperature measurement may increase.

If the temperature sensor and the voltage/current tap were separate structures from each other, separately forming a wire (for the temperature sensor) under at least one of the voltage/current taps (for measuring voltage/current) would have caused each of the voltage/current taps assembled above the wire to be positioned higher (e.g., to have a stepped position) relative to other voltage/current taps (i.e., due to the wire), thereby potentially triggering an assembly failure, e.g., non-application of potting, etc., due to the stepped position. Further, the separate wire structure with the temperature sensor would have required manual insertion into a narrow space during assembly (e.g., due to position under the voltage/current tap), resulting in insufficient remaining space for mounting the temperature sensor (e.g., only one temperature sensor), thereby causing errors in temperature measurement depending on the position of the temperature sensor.

In contrast, referring to FIG. 1, the height difference (i.e., the stepped position) is eliminated in the example embodiments, since no separate structure of a wire exists in the battery module according to the present disclosure. That is, since a same structure is used for measuring both voltage/current and temperature (i.e., a single temperature measurement board 100 is used to support measurement of both voltage/current and temperature), space may be optimized in the battery module and the height difference due to stacked multiple structures may be eliminated or substantially reduced. Further, since no separate structure of a wire exists in the battery module according to the present disclosure, manual insertion of the wire is eliminated and space is maximized to include multiple temperature measurement patterns and temperature sensors, thereby increasing temperature measurement accuracy.

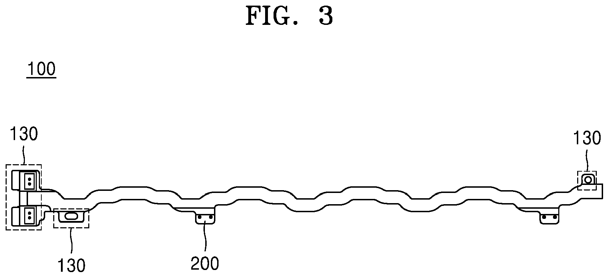

FIG. 3 schematically shows a fixing rib of a temperature measurement apparatus according to embodiments of the present disclosure. FIG. 4 schematically shows a structure where a temperature measurement apparatus according to embodiments of the present disclosure is mounted on an integrated circuit board of a BMS.

If movement was to occur in a temperature measurement apparatus bonded via a wire bonding process, an assembly failure could occur, requiring application of a fixing rib for fixing the temperature measurement apparatus. In contrast, example embodiments provide a fixing rib for fixing the temperature measurement apparatus to the integrated circuit board of the BMS.

For example, the plating layer 120 of the temperature measurement apparatus according to embodiments of the present disclosure may be electrically connected to a battery cell through wire bonding, e.g., for measuring voltage and current. For example, referring to FIGS. 3 and 4, the temperature measurement apparatus according to embodiments of the present disclosure may include a fixing rib 130 to secure connection thereof to the integrated circuit board 150 of the BMS and the entire battery module.

For example, the fixing rib 130 may be provided at a side of the temperature measurement board 100. For example, referring to FIG. 3, the temperature measurement apparatus according to embodiments of the present disclosure may include three fixing ribs 130. For example, a first fixing rib 130 may be provided at an end of the temperature measurement board 100, and second and third fixing ribs 130 may be provided at respective left and right sides of the temperature measurement board 100 along a major axis of the temperature measurement board 100, such that a total of three fixing ribs 130 may be provided. For example, as illustrated in FIG. 3, the second and third fixing ribs 130 may be at opposite ends of the temperature measurement board 100 along a major axis of the temperature measurement board 100, and may be at opposite sides of the temperature measurement board 100 along a direction perpendicular to that of the major axis, e.g., the second fixing rib 130 may be adjacent the first fixing rib 130, and the second fixing rib 130 may at an opposite end relative to the first fixing rib 130.

For example, referring to FIG. 4, the fixing rib 130 may include at least one groove 130a fixed to a protrusion 150a of the integrated circuit board 150 of the BMS. For example, referring to FIG. 4, an edge of the integrated circuit board 150 may include the protrusion 150a that is inserted into the groove 130a of the fixing rib 130.

Although the present disclosure has been described with reference to an example shown in the drawings, it will be understood by those of ordinary skill in the art that various modifications and equivalent other examples may be made from the shown example.

Those of ordinary skill in the art to which the present disclosure pertains will appreciate that the present disclosure may be implemented in different detailed ways without departing from the technical or essential characteristics of the present disclosure. The aforementioned embodiments of the present disclosure should be construed as being only illustrative, but should not be constructed as being restrictive from all aspects. For example, each element described as a single type may be implemented in a distributed manner, and likewise, elements described as being distributed may be implemented as a coupled type.

The scope of the present disclosure is defined by the following claims rather than the detailed description, and the meanings and scope of the claims and all changes or modified forms derived from their equivalents should be construed as falling within the scope of the present disclosure.

By way of summation and review, a conventional temperature sensor for measuring temperature of a battery cell may be mounted on an integrated circuit board of the BMS via a wire harness structure, and may be a completely separate structure from a voltage or a current tap for voltage and/or current measurement of the battery cell. In this case (i.e., when the temperature sensor and the voltage/current tap are completely separate structures from each other), each voltage/current tap may extend along a row of battery cells to be connected to each battery cell to allow charging/discharging current of the battery cell to flow therethrough for measuring voltage/current, and the temperature sensor may be connected to a wire, which extends under at least one of the voltage/current taps and is connected to the BMS, for measuring temperature separately from the voltage/current.

However, in the conventional battery module, the voltage/current taps are assembled such that each of the voltage/current taps assembled above the wire with the temperature sensor is positioned higher (e.g., has a stepped position) relative to other voltage/current taps (i.e., due to the wire). In this case, an assembly failure, e.g., non-application of potting, etc., may occur due to the stepped position.

Further, in the conventional battery module, the wire with the temperature sensor has to be manually inserted into a fixing rib during assembly. However, since a space where the wire is assembled is narrow, insufficient space may remain for mounting the temperature sensor (e.g., only one temperature sensor may be mounted in the conventional battery module), thereby temperature measurement may have an error depending on a position where temperature measurement is performed.

In contrast, one or more embodiments of the present disclosure include an apparatus for accurately measuring a battery temperature. That is, according to the present disclosure, an apparatus for measuring a battery temperature may be provided, which is capable of optimizing an assembling process of a battery module and accurate temperature measurement by providing simultaneous voltage/current and temperature measurement via a single structure of a plating layer and a pattern on opposite surfaces of a single board (e.g., substrate). According to the present disclosure, the apparatus for measuring a battery temperature may be provided, which is capable of optimizing the assembling process of the battery module by measuring a voltage, a current, and a temperature with one apparatus.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A temperature measurement apparatus for measuring a temperature of a battery cell, the temperature measurement apparatus comprising:
a temperature measurement board including at least one temperature sensor, the temperature measurement board being on an integrated circuit board;
a plating layer on a first surface of the temperature measurement board and electrically connected to the battery cell to allow a charging/discharging current of the battery cell to flow therethrough, the plating layer being a metal layer; and
at least one temperature measurement pattern on a second surface of the temperature measurement board and electrically connected to the at least one temperature sensor, the second surface being opposite the first surface, and the at least one temperature measurement pattern being a conductive pattern.

2. The temperature measurement apparatus as claimed in claim 1, wherein the plating layer comprises a copper foil plating layer.

3. The temperature measurement apparatus as claimed in claim 2, wherein the plating layer further comprises a nickel and gold plating layer.

4. The temperature measurement apparatus as claimed in any one of the preceding claims, wherein the plating layer is configured to allow the charging/discharging current for measuring a voltage and a current of the battery cell to flow therethrough.

5. The temperature measurement apparatus as claimed in any one of the preceding claims, wherein an end of the at least one temperature measurement pattern is electrically connected to the at least one temperature sensor to allow a temperature sensing current for measuring the temperature of the battery cell to flow therethrough.

6. The temperature measurement apparatus as claimed in claim 5, wherein the at least one temperature measurement pattern includes a plurality of temperature measurement patterns on the second surface of the temperature measurement board, and the at least one temperature sensor include a plurality of temperature sensors, the plurality of temperature measurement patterns being electrically connected to corresponding ones of the plurality of temperature sensors.

7. The temperature measurement apparatus as claimed in any one of the preceding claims, wherein the plating layer is electrically connected to the battery cell by a wire.

8. The temperature measurement apparatus as claimed in claim 7, further comprising a fixing rib at a side of the temperature measurement board, the fixing rib including at least one groove fixed to a protrusion of the integrated circuit board.

9. A battery management system comprising the temperature measurement apparatus as claimed in any one of the preceding claims.

10. A battery pack comprising the battery management system as claimed in claim 9.
